# EUROPEAN PATENT APPLICATION

(11) **EP 4 318 830 A1**
(43) Date of publication of application: **07.02.2024**
(21) Application number: 23187636.8
(22) Date of filing: 25.07.2023
(51) Int. Cl.: H01S 5/024, H01S 5/04, H01S 5/10, H01S 5/14, H01S 3/094, H01S 3/081, H01S 5/20, H01S 5/22, H01S 5/30, H01S 5/343, H01S 3/08, H01S 3/109, H01S 3/1115, H01S 5/02, H01S 5/065

(54) **LIGHT SOURCE DEVICE AND SEMICONDUCTOR DEVICE**

(30) Priority: 29.07.2022 JP 2022122158
(71) Applicant: Nichia Corporation, Anan-shi, Tokushima 774-8601 (JP)
(72) Inventor: HATAKEYAMA, Koichiro, Anan-shi, 774-8601 (JP); OKADA, Masanori, Anan-shi, 774-8601 (JP)
(74) Representative: Betten & Resch

(57) **Abstract**

A light source device includes a resonator having first and second mirrors, a gain medium disposed between the first and second mirrors and including a first semiconductor portion, an active layer, and a second semiconductor portion arranged in this order in a direction perpendicular to an optical axis of the resonator, and having first and second principal surfaces respectively located on sides of the first and second semiconductor portions opposite to sides on which the active layer is provided, a first heat dissipation member located on a first principal surface side of the gain medium, and a second heat dissipation member located on a second principal surface side of the gain medium. The resonator and the gain medium are arranged such that the optical axis passes through the gain medium.

## Description

### FIELD

The present disclosure relates to light source devices and semiconductor devices.

### BACKGROUND

A vertical external cavity surface emitting laser (VECSEL) is sometimes also referred to as a semiconductor disk laser (SDL) or an optically pumped semiconductor laser (OPSL). In general, the OPSL uses a quantum well epitaxially grown on a substrate for a laser gain, and generates laser oscillation in a direction perpendicular to the substrate. An external resonator is formed by a reflector provided between the substrate and the quantum well, and an external mirror, and a high-output single-mode laser matched to a resonator mode can be made.

A vertical surface-emitting semiconductor device including a heat sink, and a semiconductor gain structure, formed of a distributed Bragg reflector (DBR) and a quantum well, and provided on the heat sink, is proposed in Japanese Patent Publication No. 2011-71506, for example. A resonator is formed between the DBR and an external reflecting mirror, and laser light is emitted in a direction perpendicular to the heat sink.

### SUMMARY

When an intensity of excitation light is increased to obtain a high output, waste heat increases and affects an oscillation operation. Accordingly, an efficient heat dissipation structure is required.

It is one object of the present disclosure to provide a light source device having high heat dissipation.

In one embodiment, a light source device includes a resonator including a first mirror and a second mirror; a gain medium disposed between the first mirror and the second mirror, the gain medium including a first semiconductor portion, an active layer, and a second semiconductor portion that are arranged in this order in a direction perpendicular to an optical axis of the resonator, a first principal surface of the gain medium is located on a side of the first semiconductor portion opposite to a side of the first semiconductor portion on which the active layer is provided, and a second principal surface of the gain medium is located on a side of the second semiconductor portion opposite to a side of the second semiconductor portion on which the active layer is provided; a first heat dissipation member located on a first principal surface side of the gain medium; and a second heat dissipation member located on second principal surface side of the gain medium. The resonator and the gain medium are arranged such that the optical axis of the resonator passes through the gain medium.

It is to be understood that both the foregoing general description and the following detailed description are exemplary and explanatory and not restrictive of the invention.

### BRIEF DESCRIPTION OF THE DRAWINGS

FIG. 1 is a diagram illustrating a basic configuration of a main part of a light source device according to one embodiment;
FIG. 2 is a schematic diagram of a gain medium used in FIG. 1;
FIG. 3A is a plan view schematically illustrating an overall configuration of the light source device of a first configuration example;
FIG. 3B is a plan view schematically illustrating a modification of the light source device illustrated in FIG. 3A;
FIG. 4A is a plan view schematically illustrating the overall configuration of the light source device of a second configuration example;
FIG. 4B is a plan view schematically illustrating a modification of the light source device illustrated in FIG. 4A;
FIG. 5 is a diagram illustrating an example of a first manufacturing process of a gain chip;
FIG. 6A is a diagram illustrating a second manufacturing process for the gain chip;
FIG. 6B is a diagram illustrating the second manufacturing process for the gain chip;
FIG. 6C is a diagram illustrating the second manufacturing process for the gain chip;
FIG. 6D is a diagram illustrating the second manufacturing process for the gain chip;
FIG. 7 is a diagram schematically illustrating the gain chip manufactured by the processes of FIG. 6A through FIG. 6D;
FIG. 8A is a plan view illustrating a third manufacturing process;
FIG. 8B is a cross-sectional view along a line A-A in FIG. 8A;
FIG. 9A is a plan view illustrating the third manufacturing process;
FIG. 9B is a cross-sectional view along the line A-A of FIG. 9A;
FIG. 10A is a plan view illustrating the third manufacturing process;
FIG. 10B is a cross-sectional view along a line A-A in FIG. 10A;
FIG. 11 is a diagram illustrating the third manufacturing process;
FIG. 12 is a schematic diagram of the gain chip manufactured by the third manufacturing process;
FIG. 13 is a plan view for a case where an oblique active layer is formed in FIG. 10A;
FIG. 14 is a diagram illustrating a first modification of the gain chip;
FIG. 15 is a diagram illustrating a second modification of the gain chip;
FIG. 16 is a diagram illustrating a third modification of the gain chip;
FIG. 17 is a diagram illustrating a fourth modification of the gain chip;
FIG. 18 is a diagram illustrating a fifth modification of the gain chip;
FIG. 19 is a diagram illustrating a sixth modification of the gain chip;
FIG. 20 is a diagram illustrating a modification of the light source device; and
FIG. 21 is a diagram illustrating another modification of the light source device.

### DETAILED DESCRIPTION

Certain embodiments of the present disclosure will be described below with reference to the accompanying drawings. The following description is provided only for the purpose of embodying the technical idea of the present disclosure, and the present disclosure is not limited to the following description unless specifically indicated otherwise.

In the drawings, constituent elements having the same function may be designated by the same reference numerals. Although sometimes illustrated in separate embodiments for the sake of convenience in consideration of ease of explanation or ease of understanding of subject matter, configurations illustrated in different embodiments or examples may be partially substituted or combined with one another. A description of an embodiment given after a description of another embodiment will be focused mainly on matters different from those of the already described embodiment, and a duplicate description may be omitted with respect to the matters shared with the already described embodiment. The sizes, positional relationships, and the like of constituent elements illustrated in the drawings may sometimes be exaggerated for clearer illustration.

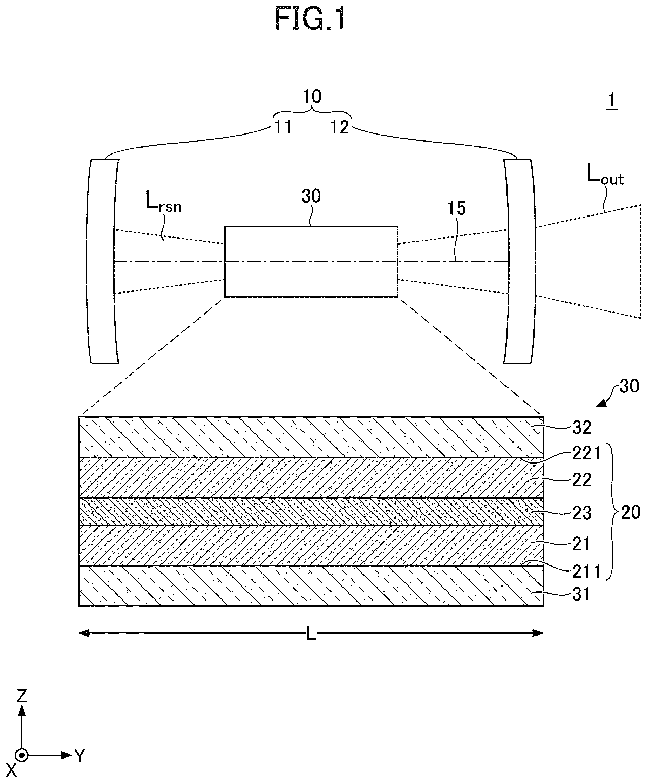

FIG. 1 illustrates a basic configuration of a main part of a light source device 1 according to one embodiment. The light source device 1 includes a resonator 10 having a first mirror 11 and a second mirror 12, a gain medium 20 disposed between the first mirror 11 and the second mirror 12, a first heat dissipation member (or first heat sink) 31 provided on a first principal surface 211 side of the gain medium 20, and a second heat dissipation member (or second heat sink) 32 provided on a second principal surface 221 side of the gain medium 20. The gain medium 20, the first heat dissipation member 31, and the second heat dissipation member 32 form a gain chip 30. The first principal surface 211 is located on a side of a first semiconductor portion 21 opposite to a side of the first semiconductor portion 21 on which an active layer 23 is provided, and the second principal surface 221 is located on a side of a second semiconductor portion 22 opposite to a side of the second semiconductor portion 22 on which the active layer 23 is provided. The resonator 10 and the gain medium 20 are disposed so that an optical axis 15 of the resonator 10 passes through the gain medium 20. The optical axis 15 of the resonator 10 can be defined according to an arrangement of the first and second mirrors 11 and 12 forming the resonator 10.

The gain medium 20 includes the first semiconductor portion 21, the active layer 23, and the second semiconductor portion 22 that are arranged in this order along a direction perpendicular to the optical axis 15 of the resonator 10. The term "perpendicular" not only refers to a case where an angle formed between a first direction and a second direction is exactly 90 degrees, but rather also allows for a design error up to ±0.5 degrees. On the other hand, the term "parallel" not only refers to a case where an angle formed between the first direction and the second direction is exactly 180 degrees, but rather also allows for a design error up to ±0.5 degrees.

In a coordinate system used in FIG. 1, it is assumed for the sake of convenience that the direction of the optical axis 15 of the resonator 10 is a Y-direction, a layering direction of the active layer 23 is a Z-direction, and a direction orthogonal to the Y-direction and the Z-direction is an X-direction. The gain chip 30 includes the optical axis 15, and has a layered structure in the ZY-plane in which the optical axis 15 extends, as illustrated in FIG. 1. A size of the gain medium 20 in a direction (Y-direction in FIG. 1) along the optical axis 15 of the resonator 10 is defined as a length L of the gain medium 20. The length L is appropriately set according to a resonator length (a length of the optical axis 15 between the first mirror 11 and the second mirror 12), a target output, and the like. The length L of the gain medium 20 may be in a range greater than or equal to 1 mm and less than or equal to 10 mm, for example.

### <Mirror>

Light Lrsn reciprocating between the first mirror 11 and the second mirror 12 of the resonator 10 is amplified each time the light Lrsn passes through the gain medium 20. For the sake of convenience, the light Lrsn reciprocating between the first mirror 11 and the second mirror 12 may also be referred to as resonant light Lrsn in the present specification. When a gain obtained by the reciprocating light in the resonator 10 exceeds a loss of the resonator 10, the light source device 1 oscillates at a constant intensity. The loss of the resonator 10 can be approximated by a sum of a loss due to transmission from an output-side mirror (for example, the second mirror 12) to an outside of the resonator 10, and a loss inside the resonator 10. Output light output from the second mirror 12 to the outside of the resonator 10 is denoted by Lout. The first mirror 11 may be provided with a reflective film. The second mirror 12 may be provided with a partial reflection film.

### <Heat Dissipation Member>

Unlike a general OPSL, in the gain chip 30 of the light source device 1, the resonant light Lrsn is input and output in a direction parallel to the first heat dissipation member 31 and the second heat dissipation member 32. Accordingly, in the gain chip 30, a large gain can be obtained, because an interaction length of the resonant light Lrsn and the gain medium 20 can be made longer than that of the general OPSL. In addition, the first heat dissipation member 31 and the second heat dissipation member 32 are respectively provided on the first principal surface 211 and the second principal surface 221 each having a large area, with the gain medium 20 interposed therebetween. Hence, a high heat dissipation performance can be obtained compared to the general OPSL in which a heat dissipation member is only provided on one surface. Moreover, because a direction of the heat dissipation is different from a direction of the resonance, a DBR does not need to be provided between the first heat dissipation member 31 and the gain medium 20, or between the second heat dissipation member 32 and the gain medium 20, and the heat dissipation performance can further be improved.

The first heat dissipation member 31 and the second heat dissipation member 32 may be formed of aluminum nitride, copper, silicon carbide, diamond, a composite material of metal and diamond, graphite, or a composite material of metal and graphite, for example. The first heat dissipation member 31 is preferably formed of a material having a linear expansion coefficient with a small difference from a linear expansion coefficient from the first semiconductor portion 21. In a case where the first semiconductor portion 21 is formed of a nitride semiconductor, for example, the first heat dissipation member 31 may be formed of aluminum nitride. The first heat dissipation member 31 may be formed of two or more kinds of materials. The first heat dissipation member 31 may include aluminum nitride and copper that are arranged in this order from the side closer to the gain medium 20, for example. Because a linear expansion coefficient of aluminum nitride can take a value between a linear expansion coefficient of the gain medium 20 and a linear expansion coefficient of copper, it is possible to improve the heat dissipation performance while increasing an adhesion between the gain medium 20 and the first heat dissipation member 31. For similar reasons, the first heat dissipation member 31 may include aluminum nitride and a composite material of metal and diamond that are arranged in this order from the side closer to the gain medium 20, for example. Similarly to the first heat dissipation member 31, the second heat dissipation member 32 may be formed of two or more kinds of materials. In addition, the first heat dissipation member 31 and the second heat dissipation member 32 preferably have identical configurations. As a result, when the light source device 1 operates, heat is dissipated in a similar manner from the first heat dissipation member 31 and the second heat dissipation member 32, to thereby reduce a bias in the heat in the gain medium 20, and obtain laser light with a high intensity. Bonding of the first heat dissipation member 31 and the gain medium 20, and bonding between the second heat dissipation member 32 and the gain medium 20, can be achieved by direct bonding. Examples of the direct bonding include surface activated bonding, atomic diffusion bonding, hydroxyl group bonding, and the like, for example.

### <Gain Medium>

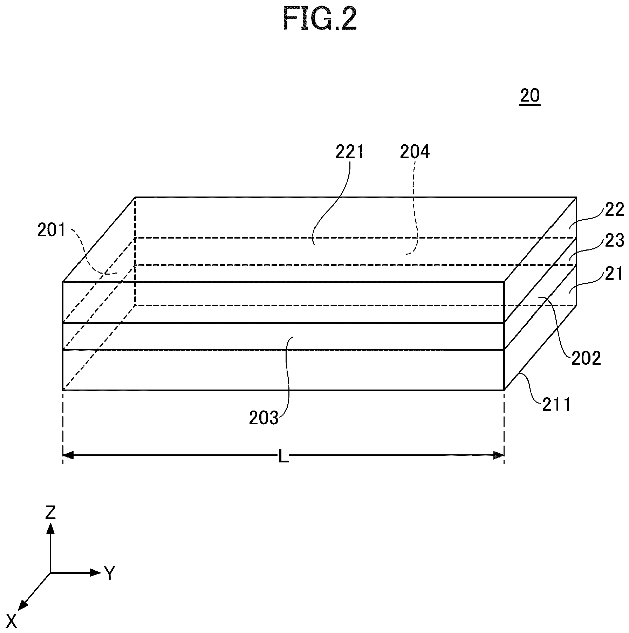

FIG. 2 is a perspective view of the gain medium 20. In the gain medium 20, the first semiconductor portion 21, the active layer 23, and the second semiconductor portion 22 are arranged in this order, for example. In other words, in the gain medium 20, the active layer 23 is disposed between the first semiconductor portion 21 and the second semiconductor portion 22. As illustrated in FIG. 2, the gain medium 20 has a hexahedron shape, for example. Two surfaces on opposite sides of the gain medium 20, parallel to the XY-plane perpendicular to the layering direction (or Z-direction), form the first principal surface 211 and the second principal surface 221. The first principal surface 211 is located on the side of the first semiconductor portion 21 opposite to the side provided with the active layer 23. The second principal surface 221 is located on the side of the second semiconductor portion 22 opposite to the side provided with the active layer 23.

Four surfaces connecting the first principal surface 211 and the second principal surface 221 are referred to as side surfaces 201, 202, 203, and 204. Among the four surfaces, the side surfaces 201 and 202 through which the resonant light Lrsn is input and output may also be referred to as input and output surfaces of the gain medium 20 for the resonant light Lrsn. The input and output surfaces are preferably the side surfaces including the short side among the four sides of the first principal surface 211 and/or the second principal surface 221. Thus, an optical path through which the resonant light Lrsn passes through the gain medium 20 can be made long, and the light can be efficiently amplified. In a case where the gain medium 20 has the shape of other polyhedrons, the pair of side surfaces serving as the input and output surfaces may be appropriately set so that the optical path through which the resonant light Lrsn passes through the gain medium 20 becomes long. The side surfaces 201 and 202 may be cleaved surfaces, or may be formed by a method other than cleaving, such as polishing, chemical mechanical polishing, and the like, or may be formed by a combination of additional processes or steps after the cleaving. The remaining pair of opposing side surfaces 203 and 204 may be used for input and output of excitation light, as will be described below.

The first semiconductor portion 21 and the second semiconductor portion 22 may be formed of a group III-V semiconductor. The first semiconductor portion 21 and the second semiconductor portion 22 may be formed of a semiconductor material, such as a GaN-based semiconductor material, a GaAs-based semiconductor material, and the like, for example. In the present embodiment, a material preferably used for the first semiconductor portion 21 and the second semiconductor portion 22 is the GaN-based semiconductor material. In a case where the OPSL is formed of the GaN-based semiconductor material, an improvement is required with respect to, for example, the following points, compared to a case where the OPSL is formed of the GaAs-based material.

A first point to be improved is the excitation method. Because the GaN-based semiconductor material has a smaller gain per unit power of excitation light than the GaAs-based semiconductor material, efficient excitation of the gain medium 20 is required. In the light source device 1 forming the OPSL of the present embodiment, the direction of the optical axis 15 defined by the resonator 10 is different from the direction in which the gain medium 20 dissipates heat to the first and second heat dissipation members 31 and 32. In addition, the optical axis 15 defined by the resonator 10 passes through the side surfaces 201 and 202 of the gain medium 20. Accordingly, a length of the resonant light Lrsn between the input and output surfaces (that is, the side surfaces 201 and 202) becomes the interaction length of the resonant light Lrsn and the active layer 23, thereby making it possible to efficiently amplify the light.

A second point to be improved is the heat dissipation. When the output of the excitation light is increased in order to compensate for the small gain of the GaN-based semiconductor material, the heat generated in the gain medium 20 increases. In the light source device 1 according to the present embodiment, because the gain medium 20 is disposed between the first heat dissipation member 31 and the second heat dissipation member 32, the number of heat dissipation paths increases compared to a conventional OPSL, to thereby improve the heat dissipation performance. In addition, because the DBR is not used between the gain medium 20 and the first heat dissipation member 31, or between the gain medium 20 and the second heat dissipation member 32, the mirror does not interfere with the heat dissipation when compared to the conventional OPSL.

As described above, in the light source device 1 according to the present embodiment, it is particularly preferable to use the GaN-based semiconductor material for the first semiconductor portion 21 and the second semiconductor portion 22.

Because the gain medium 20 is optically excited (or optically pumped), intentional addition of an impurity is not necessarily required, but an impurity may be included in a portion of the first semiconductor portion 21 or the second semiconductor portion 22 as long as the concentration of the impurity is sufficiently low such that little optical absorption occurs. At least one of the first semiconductor portion 21 and the second semiconductor portion 22 may have a portion including the impurity with a concentration less than or equal to 1 × 10¹⁷ cm⁻³, for example. The impurity may be an n-type impurity, such as Si, Ge, and the like, or a p-type impurity, such as Mg and the like, for example. In addition, at least one of the first semiconductor portion 21 and the second semiconductor portion 22 may include a plurality of semiconductor layers. The plurality of semiconductor layers may include a layer including impurities with a relatively low concentration, and a layer including impurities with a relatively high concentration. In this case, the layer including the impurity with the relatively high concentration may be located at a position more distant from the active layer 23, or at a position closer to the first heat dissipation member 31 or the second heat dissipation member 32 than to the active layer 23, when compared to the layer including the impurity with the relatively low concentration, so that the light absorption hardly occurs. The layer including the impurity with the relatively high concentration is preferably separated from the active layer 23 by a distance greater than a length corresponding to a diameter of a beam passing through the gain medium 20. The layer including the impurity with the relatively high concentration may be separated from the active layer 23 by a distance greater than or equal to 500 pm, for example.

In a case where the nitride semiconductor is used for the first semiconductor portion 21 and the second semiconductor portion 22, the first heat dissipation member 31 and the second heat dissipation member 32 are preferably formed of a metal nitride. In this case, a difference between the thermal expansion coefficients of the nitride semiconductor and the metal nitride can be made relatively small. Examples of the metal nitride include AlN, GaN, BN, and the like, for example.

A thickness of the active layer 23 may be in a range greater than or equal to 50 nm and less than or equal to 2000 nm, for example. In this case, the resonant light Lrsn can be efficiently amplified. In addition, the thickness of the active layer 23 may be in a range greater than or equal to 50 nm and less than or equal to 500 nm, for example. In this case, it is possible to reduce a deterioration in crystallinity of the active layer 23. The active layer 23 has a multi-quantum well structure including a plurality of well layers, and a plurality of barrier layers, for example. In the case where the active layer 23 has the multi-quantum well structure, a material used for the well layers is GaN, InGaN, or AlGaN, for example, and a material used for the barrier layers is AlGaN, GaN, or InGaN, for example. A period of the multi-quantum wells, and a thickness of the well layers and the barrier layers may be appropriately designed according to a target wavelength. Alternatively, the material used for the active layer 23 may be a nitride added with a rare-earth element. The active layer 23 may be GaN added with Eu, for example. At least a portion of the resonant light Lrsn propagates through the active layer 23, to thereby amplify the resonant light Lrsn. The active layer 23 may be formed to a thickness smaller than a beam diameter of the resonant light Lrsn, but the optical axis of the resonant light Lrsn preferably passes through the active layer 23. The beam diameter of the resonant light Lrsn incident on the active layer 23 may be narrowed by forming mutually opposing surfaces of the first mirror 11 and the second mirror 12 into concave surfaces having an appropriate curvature. A condenser lens may be used as long as the optical loss inside the resonator 10 does not become excessively large.

### <First Configuration Example>

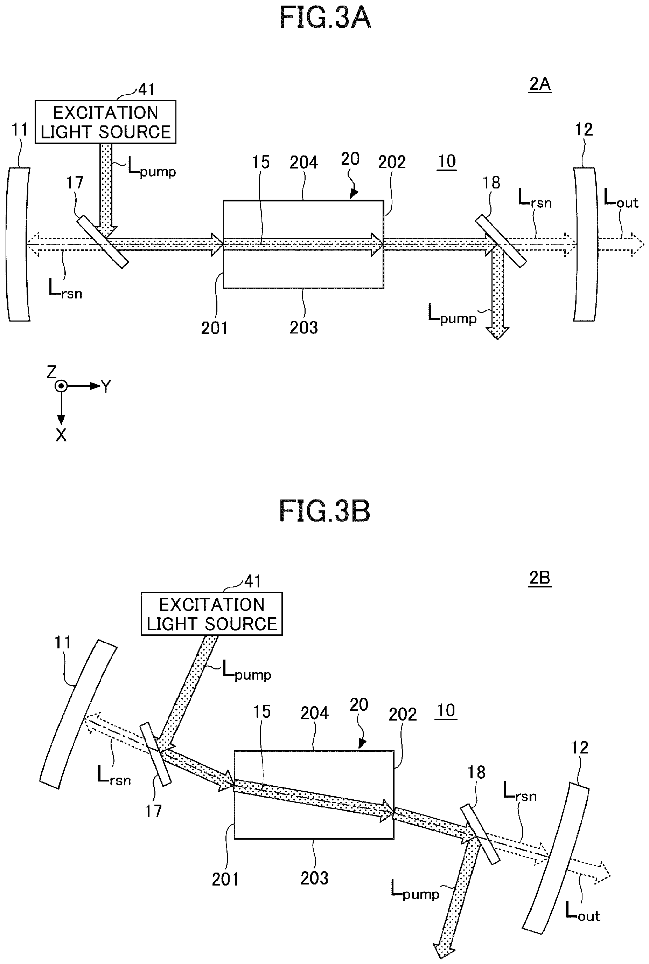

FIG. 3A is a plan view schematically illustrating an overall configuration of a light source device 2A of a first configuration example. The light source device 2A includes the resonator 10 having the first mirror 11 and the second mirror 12, the gain medium 20 disposed between the first mirror 11 and the second mirror 12, and an excitation light source (or pumping source) 41 disposed outside the resonator 10. Although the illustration of the first heat dissipation member 31 and the second heat dissipation member 32 is omitted in FIG. 3A for the sake of convenience in order to illustrate optical paths of the resonant light Lrsn and an excitation light Lpump, the first heat dissipation member 31 and the second heat dissipation member 32 are provided on the first principal surface and the second principal surface of the gain medium 20, respectively, similarly to the light source device 1 of FIG. 1.

The excitation light Lpump output from the excitation light source 41 is incident on the active layer of the gain medium 20 along the optical axis 15 of the resonator 10. The excitation light Lpump may be incident on the side surface 201, that is the input and output surface of the resonant light Lrsn, coaxially with the resonant light Lrsn. The excitation light Lpump output from the excitation light source 41 is bent by an optical element 17 in a direction along the optical axis 15 of the resonator 10.

The optical element 17 may be a polarization beam splitter, for example. In this case, a polarization of the excitation light Lpump and a polarization of the resonant light Lrsn are adjusted to be orthogonal to each other. A population inversion is formed in the gain medium 20 by the excitation light Lpump incident on the gain medium 20. A portion of the resonant light Lrsn amplified by the gain medium 20 is output from the second mirror 12. In a case where a wavelength of the excitation light Lpump and a wavelength of the resonant light Lrsn differ by such an amount that enables separation (using a dichroic mirror, for example), a dichroic mirror may be used for the optical element 17. Surplus excitation light Lpump may be emitted to the outside of the resonator 10 by an optical element 18.

FIG. 3B is a plan view schematically illustrating a light source device 2B. The light source device 2B is a modification of the light source device 2A illustrated in FIG. 3A. In the light source device 2B, the resonant light Lrsn is incident on the side surface 201 of the gain medium 20 at a Brewster's angle. In other words, an angle formed between the optical axis 15 defined by the resonator 10 and the side surface 201 of the gain medium 20 is the Brewster's angle. Similarly, an angle formed between the optical axis 15 defined by the resonator 10 and the side surface 202 of the gain medium 20 may be the Brewster's angle. By making the resonant light Lrsn to become incident on the gain medium 20 at the Brewster's angle, it is possible to reduce reflection at the side surfaces 201 and 202. In this configuration, an antireflection film does not need to be provided on the side surfaces 201 and 202 with respect to the resonant light Lrsn. In addition, because the resonant light Lrsn is incident on the side surface 201 and the side surface 202 at the Brewster's angle, the resonant light Lrsn propagates obliquely between the side surface 201 and the side surface 202, to thereby increase the length of the optical path inside the gain medium 20. Accordingly, the resonant light Lrsn can efficiently resonate, and output light Lout can be obtained with a higher output. In the case where the optical element 17 is the dichroic mirror, because the excitation light Lpump is also guided to the gain medium 20 along the optical axis 15 of the resonator 10, the excitation light Lpump is incident on the side surface 201 of the gain medium 20 near the Brewster's angle with respect to the excitation light Lpump. Thus, the reflection at the side surfaces 201 and 202 can be reduced. Near the Brewster's angle may include an error within ±1 degree with respect to the Brewster's angle.

### <Second Configuration Example>

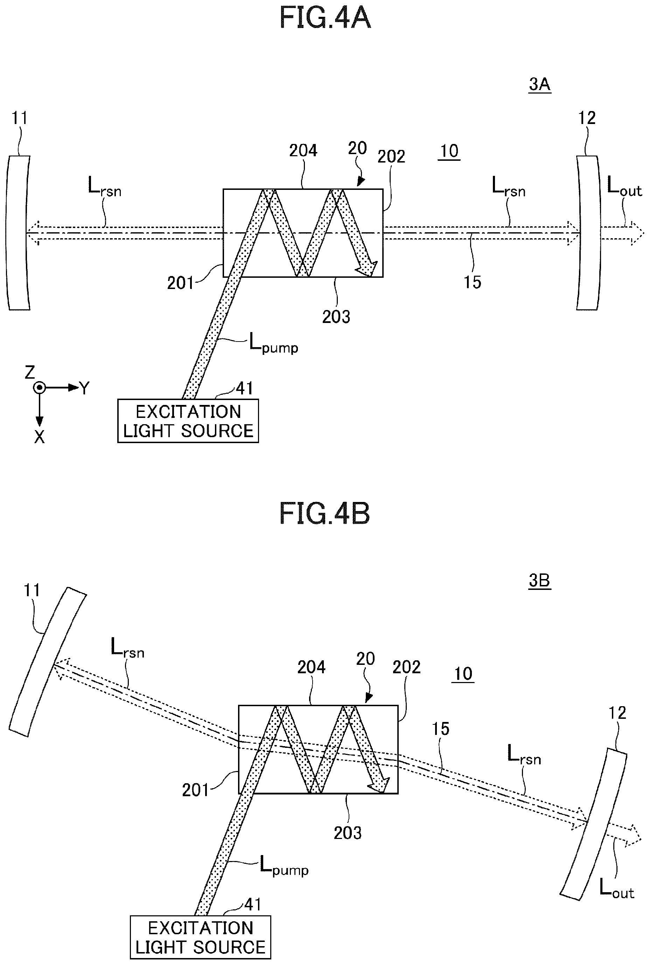

FIG. 4A is a plan view schematically illustrating an overall configuration of a light source device 3A of a second configuration example. The light source device 3A includes the resonator 10 having the first mirror 11 and the second mirror 12, the gain medium 20 disposed between the first mirror 11 and the second mirror 12, and the excitation light source 41 disposed outside the resonator 10. In the second configuration example, the excitation light Lpump is incident on the active layer 23 of the gain medium 20 in a direction intersecting the optical axis 15 of the resonator 10. Although the illustration of the first heat dissipation member 31 and the second heat dissipation member 32 is omitted in FIG. 4A for the sake of convenience in order to illustrate the optical paths of the resonant light Lrsn and the excitation light Lpump, the first heat dissipation member 31 and the second heat dissipation member 32 are provided on the first principal surface and the second principal surface of the gain medium 20, respectively, similarly to the light source device 1 of FIG. 1.

The excitation light Lpump output from the excitation light source 41 is incident on the gain medium 20 from the side surface 203 or the side surface 204 of the gain medium 20. The excitation light Lpump incident on the side surface 203 or the side surface 204 propagates while being reflected inside the gain medium 20, and excites most of the active layer 23. Hence, the interaction length of the resonant light Lrsn and the excited active layer 23 increases, and the resonant light Lrsn is efficiently amplified. For example, by forming reflective films on the side surfaces 203 and 204, respectively, the excitation light Lpump can be reflected. In this case, a reflection film is not provided at a portion to which the excitation light Lpump is incident. In addition, the excitation light Lpump may be incident on the side surface 201, and the gain medium 20 may be excited utilizing total reflection. The side surfaces 203 and 204 may be orthogonal to the side surfaces 201 and 202 through which the resonant light Lrsn is input and output. The term "orthogonal" not only refers to a case where an angle formed between two parts or components is exactly 90 degrees, but rather allows for a design error to a certain extent, similarly to the term "perpendicular" described above. As long as the population inversion is formed inside the gain medium 20, an incident direction of the excitation light Lpump may not necessarily be a direction along the optical axis 15 of the resonator 10. In addition, two or more excitation light sources 41 may be provided. In this case, the two or more excitation light sources 41 are disposed so that the excitation lights Lpump therefrom are incident on the side surface 203 or the side surface 204 at different positions. Attenuation of the excitation light Lpump occurs as the excitation light Lpump passes through the active layer 23. In the configuration described above, because the two or more excitation light sources 41 are disposed so that the excitation lights Lpump are incident on the active layer 23 at different positions, it is possible to more uniformly excite the entire active layer 23.

FIG. 4B is a plan view schematically illustrating a light source device 3B. The light source device 3B is a modification of the light source device 3A illustrated in FIG. 4A. In the light source device 3B, the resonant light Lrsn is incident on the side surface 201 of the gain medium 20 at the Brewster's angle. Because the resonant light Lrsn is incident on the gain medium 20 at the Brewster's angle, the reflection at the side surfaces 201 and 202 can be reduced. In this configuration, an antireflection film does not need to be provided on the side surfaces 201 and 202 with respect to the resonant light Lrsn. In this case, two or more excitation light sources 41 may be provided, similarly to the light source device 3A.

### <Manufacturing Gain Chip>

### <First Manufacturing Process>

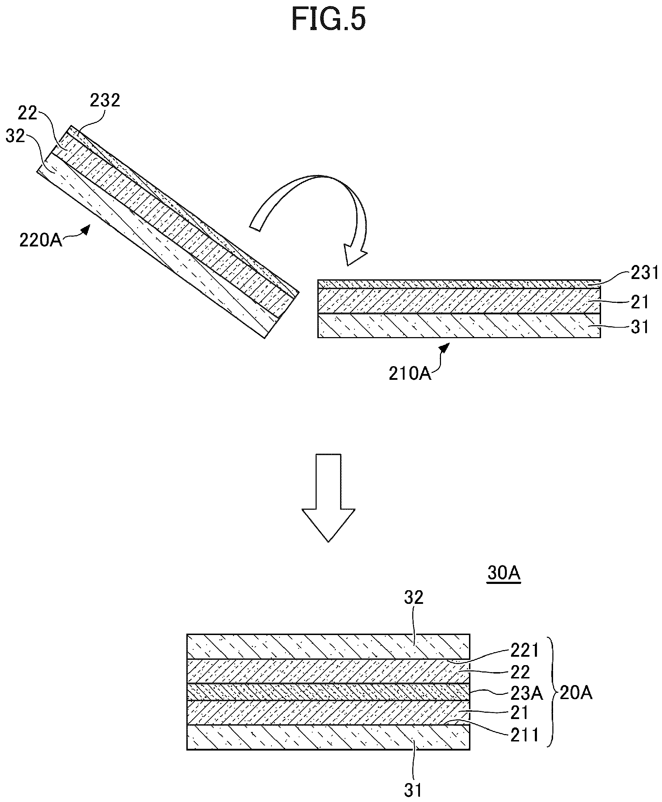

FIG. 5 is a diagram illustrating an example of a first manufacturing process of a gain chip 30A. When manufacturing the gain chip 30A, a first chip 210A and a second chip 220A are prepared. The first chip 210A includes the first heat dissipation member 31, the first semiconductor portion 21, and a first active layer 231 that are arranged in this order. The second chip 220A includes the second heat dissipation member 32, the second semiconductor portion 22, and a second active layer 232 that are arranged in this order. In the first chip 210A, the first heat dissipation member 31 may be directly bonded to the first semiconductor portion 21 on which the first active layer 231 is layered. Similarly, in the second chip 220A, the second heat dissipation member 32 may be directly bonded to the second semiconductor portion 22 on which the second active layer 232 is layered. The order of manufacturing the first chip 210A and the second chip 220A is not particularly limited.

When forming the first semiconductor portion 21 and the second semiconductor portion 22 of a nitride semiconductor, and forming the first heat dissipation member 31 and the second heat dissipation member 32 of a metal nitride, two metal nitride substrates may be provided. In this case, a nitride semiconductor layer and an active layer may be grown in order on each of the two metal nitride substrates. The first semiconductor portion 21 and the second semiconductor portion 22 may be formed by halide vapor phase epitaxy (HVPE), tri-halide vapor phase epitaxy (THVPE), ammonothermal, flux method, or the like, for example. The first and second active layers 231 and 232 may be epitaxially grown on the first semiconductor portion 21 and the second semiconductor portion 22, respectively, by metal organic chemical vapor deposition (MOCVD) or physical vapor deposition (PVD), for example. Examples of the PVD include sputtering, and molecular beam epitaxy, for example. When using a metal having a high thermal conductivity for the first heat dissipation member 31 and the second heat dissipation member 32, a metal film may be bonded to a back surface of a GaN substrate after growing the active layer on a front surface of the GaN substrate.

The first active layer 231 of the first chip 210A, and the second active layer 232 of the second chip 220A are arranged to oppose each other, and the first active layer 231 and the second active layer 232 are bonded to each other. The first active layer 231 and the second active layer 232 can be bonded by the atomic diffusion bonding, the surface activated bonding, the hydroxyl group bonding, or the like. A composition of the first active layer 231 is preferably identical to a composition of the second active layer 232. In this case, when the resonant light Lrsn passes through the gain medium, the wavelength amplified by the first active layer 231 and the wavelength amplified by the second active layer 232 become identical, and the resonant light Lrsn can be efficiently amplified.

### <Surface Activated Bonding>

When bonding the first active layer 231 and the second active layer 232 by the surface activated bonding, bonding surfaces of the first active layer 231 and the second active layer 232 are planarized to a surface roughness (Ra) less than or equal to 5 nm, and preferably less than or equal to 1 nm, for example. Thereafter, the planarized surfaces of the first active layer 231 and the second active layer 232 are cleaned by ion irradiation and activated in a vacuum. After the activation, the activated surfaces of the first active layer 231 and the second active layer 232 are made to make direct contact with each other. The first active layer 231 and the second active layer 232 are bonded by these processes or steps. A pressure may be applied when performing these bonding processes or steps. The applied pressures may be in a range greater than or equal to 10 MPa and less than or equal to 200 MPa, for example. In addition, a temperature during the bonding may be in a range greater than or equal to 0°C and less than or equal to 70°C, and more preferably in a range greater than or equal to 0°C and less than or equal to 50°C, for example. A bonding interface generated by the surface activated bonding may be amorphous or crystalline.

### <Atomic Diffusion Bonding>

When bonding the first active layer 231 and the second active layer 232 by the atomic diffusion bonding, the surfaces of the first active layer 231 and the second active layer 232 are planarized to a surface roughness (Ra) less than or equal to 5 nm, and preferably less than or equal to 1 nm, for example. Thereafter, metal films are formed on the surfaces of the first active layer 231 and the second active layer 232 by sputtering or the like in a vacuum, and the metal films are brought into contact with each other. Thus, the first active layer 231 and the second active layer 232 can be bonded to each other. One kind of metal or an alloy of two or more kinds of metals may be selected for the metal films, according to the adhesion to the first active layer 231 and the second active layer 232, and light transmission properties with respect to the excitation light Lpump and the resonant light Lrsn. Specific examples of the metal include aluminum, gold, silver, copper, gallium, silicon, nickel, platinum, titanium, ruthenium, and tantalum. In addition, different metals or different alloys may be deposited for the first active layer 231 and the second active layer 232. A thickness of the metal film may be in a range greater than or equal to 0.2 nm and less than or equal to 10 nm, or in a range greater than or equal to 0.4 nm and less than or equal to 5 nm, for example. A pressure may be applied during the bonding of the first active layer 231 and the second active layer 232. The pressure applied during the bonding may be in a range greater than or equal to 10 MPa and less than or equal to 200 MPa, for example. A temperature during the bonding may be in a range greater than or equal to 0°C and less than or equal to 70°C, for example. The metal films used for the atomic diffusion bonding does not necessarily need to be in a uniform state. Instead of uniformly providing the metal films on the first active layer 231 and the second active layer 232, the metal films may be partially provided on the first active layer 231 and the second active layer 232. The bonding interface generated by the atomic diffusion bonding may be partially modified by laser light or microwaves. For example, a transmittance of the wavelength of the excitation light Lpump can be increased with respect to the metal film in the optical path of the excitation light Lpump. In addition, a transmittance of the wavelength of the resonant light Lrsn can be increased with respect to the metal film in the optical path of the resonant light Lrsn. Further, the atomic diffusion bonding is not limited to using the metal films, and oxide films or nitride films may be used instead.

A gain chip 30A, including a gain medium 20A provided with an active layer 23A, is obtained by bonding the first active layer 231 and the second active layer 232. In the gain medium 20A, the first semiconductor portion 21, the active layer 23A, and the second semiconductor portion 22 are arranged in this order. A thickness of the active layer 23A may be in a range greater than or equal to 50 nm and less than or equal to 2000 nm, more preferably in a range greater than 50 nm and less than or equal to 1000 nm, for example. The first heat dissipation member 31 is provided on the first principal surface 211 of the gain medium 20A (that is, the surface of the first semiconductor portion 21 on the side opposite to the side of the first semiconductor portion 21 making contact with the active layer 23A), and the second heat dissipation member 32 is provided on the second principal surface 221 (that is, the surface of the second semiconductor portion 22 on the side opposite to the side of the second semiconductor portion 22 making contact with the active layer 23A). In this case, the gain chip 30A having a high heat dissipation performance can be obtained.

### <Second Manufacturing Process>

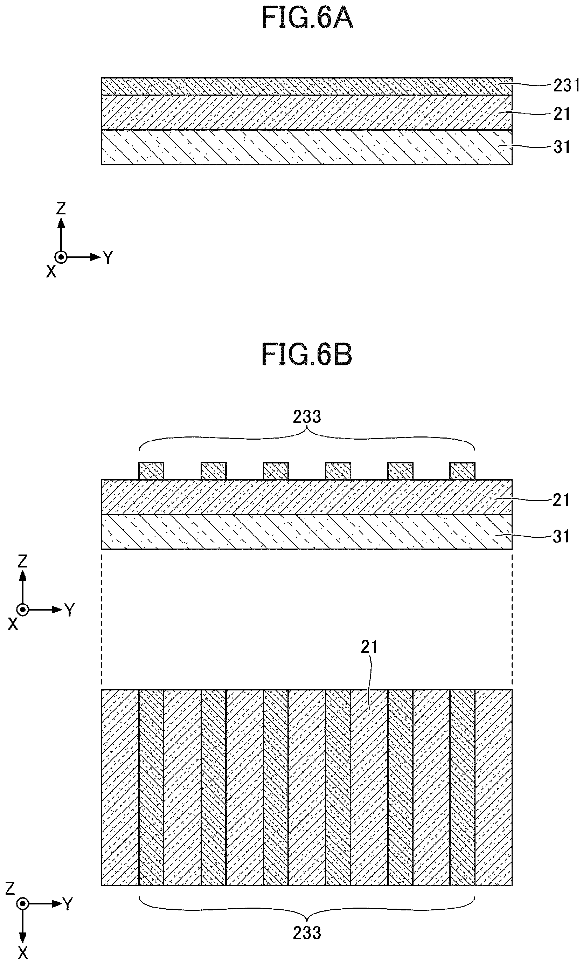

FIG. 6A through FIG. 6D illustrate a second manufacturing process of the gain chip. In the second manufacturing process, the active layer is provided only in regions corresponding to antinodes of a standing wave of the resonant light Lrsn generated in the resonator 10. This is because, in regions other than the regions corresponding to the antinodes of the standing wave, providing the active layer hardly contributes to the amplification of light. Such a structure in which the active layer is provided only in the regions corresponding to the antinodes of the standing wave in the resonator, is called a resonant periodic gain (RPG) structure.

In FIG. 6A, a chip including the first heat dissipation member 31, the first semiconductor portion 21, and the first active layer 231 that are arranged in this order, is prepared. This chip may be identical to the first chip 210A of FIG. 5. As an example, the first heat dissipation member 31 may be formed of AlN, the first semiconductor portion 21 may be formed of GaN, and the first active layer 231 may have a multi-quantum well structure of InₓGa₁₋ₓN/In_{y}Ga_{1-y}N (0 <= x <= 1, y <= 1, x < y) .

In FIG. 6B, the first active layer 231 is processed to form a periodic pattern 233. The periodic pattern is formed of the first active layer 231. The periodic pattern 233 includes stripe-shaped protrusions provided at positions corresponding to the antinodes of the standing wave in the resonator 10. The periodic pattern 233 can be formed by patterning the first active layer 231 through a mask that is formed on the first active layer 231, by electron beam lithography, and then performing dry etching, for example. A distance (or spacing) from one stripe-shaped protrusion to an adjacent stripe-shaped protrusion may be in a range greater than or equal to 50 nm and less than or equal to 200 nm, for example. In the case where the active layer is formed of the nitride semiconductor, the spacing between the adjacent stripe-shaped protrusions may be in a range greater than or equal to 75 nm and less than or equal to 100 nm, for example.

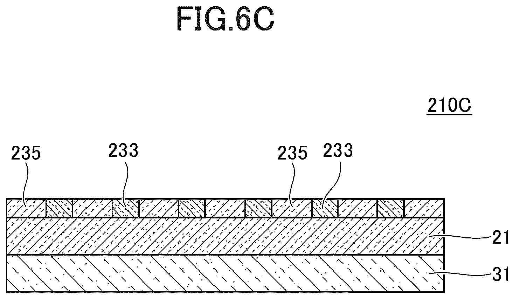

In FIG. 6C, a layer of the material (for example GaN) of the first semiconducting portion 21 is regrown in regions of the first active layer 231 removed by the etching, to fill the regions in between the periodic patterns 233 with a regrown layer 235. Thereafter, surfaces of the periodic pattern 233 and the regrown layer 235 are planarized. Thus, a first chip 210C having the periodic pattern 233 is obtained.

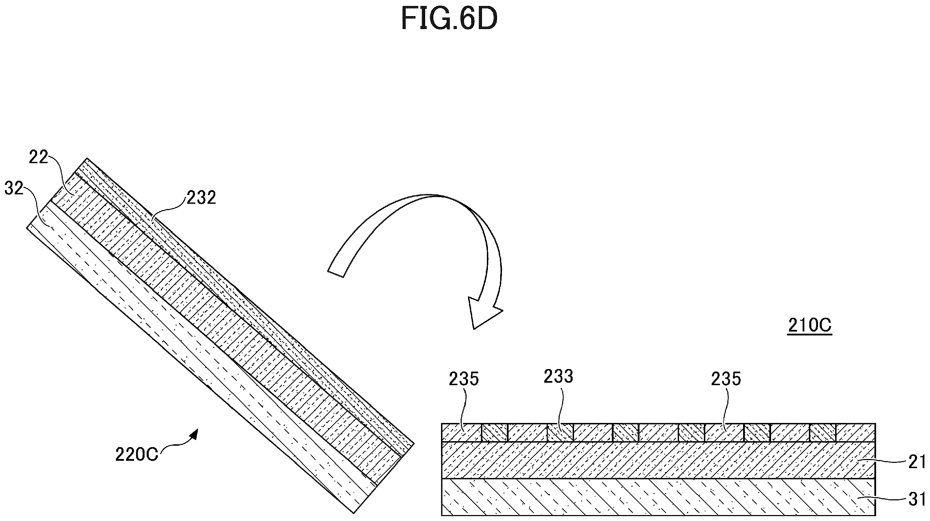

In FIG. 6D, a second chip 220C is prepared. In the second chip 220C, the second heat dissipation member 32, the second semiconductor portion 22, and the second active layer 232 are arranged in this order. The second active layer 232 does not have a periodic pattern. The second chip 220C and the first chip 210A are positioned so that the second active layer 232 opposes the first active layer 231, and the second active layer 232 is directly bonded to the periodic pattern 233 formed by the first active layer 231 of the first chip 210B by making contact therewith. During this bonding process or step, a strict alignment between periodic patterns is not required, and the manufacturing process is simple.

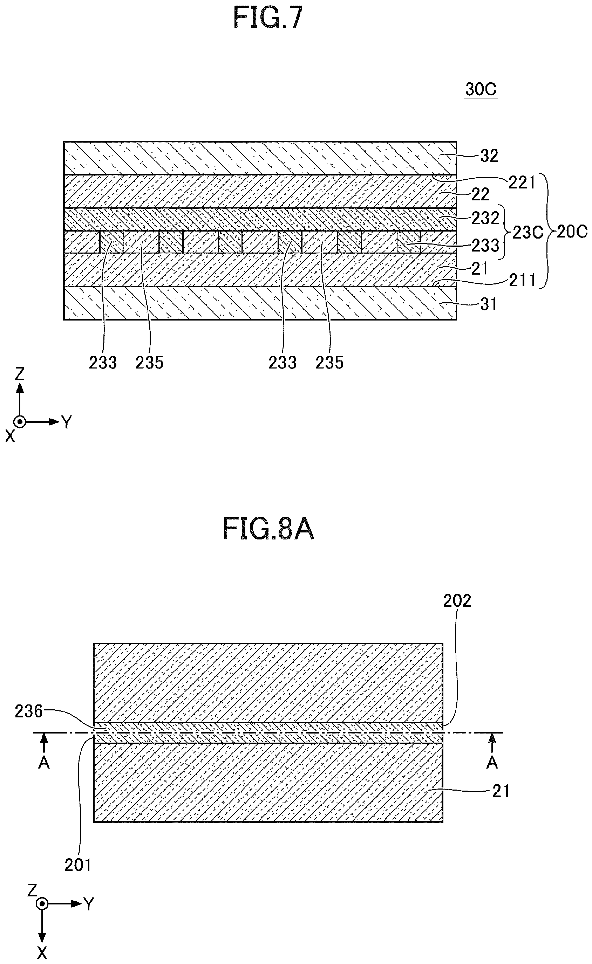

FIG. 7 is a diagram schematically illustrating a gain chip 30C manufactured by the second manufacturing process. The gain chip 30C includes a gain medium 20C, the first heat dissipation member 31 provided on the first principal surface 211 of the gain medium 20C, and a second heat dissipation member 32 provided on the second principal surface 221 of the gain medium 20C. The gain medium 20C includes the first semiconductor portion 21, an active layer 23C, and the second semiconductor portion 22 that are arranged in this order. The active layer 23C includes a periodic pattern 233 formed of the first active layer 231, and the second active layer 232 having no periodic pattern. When the gain chip 30C is disposed inside the resonator 10, a direction in which the periodic pattern 233 of the active layer 23C periodically occurs may be parallel to the direction in which the optical axis 15 (refer to FIG. 1) of the resonator 10 extends. Because the periodic pattern 233 has an RPG structure and is provided at a position corresponding to the antinode of the standing wave in the resonator 10, absorption of the excitation light Lpump by the active layer at a portion that does not contribute to the amplification of the resonant light Lrsn can be reduced, and the active layer can be efficiently excited. In addition, the regrown layer 235 is located at the light input and output surfaces of the gain chip 30C. For this reason, the periodic pattern 233 is protected by the regrown layer 235, and it is possible to reduce a deterioration of the active layer 23C.

### <Third Manufacturing Process>

FIG. 8A through FIG. 11 illustrate a manufacturing process of the gain chip 30D, as a third manufacturing process. In the third manufacturing process, when disposing the gain chip 30D inside the resonator 10, the active layer is formed so that a periodic pattern is present only in the regions along the optical axis 15 of the resonator 10. More particularly, the active layer corresponds to the antinode of the standing wave generated in the resonator 10, and is provided in the regions along the optical path of the resonant light Lrsn. Because the active layer has a large absorption with respect to the excitation light Lpump, it is preferable to remove portions of the active layer that do not contribute to the resonance. Hence, the power of the excitation light Lpump is not easily attenuated, and it is possible to efficiently excite the active layer, and increase the gain.

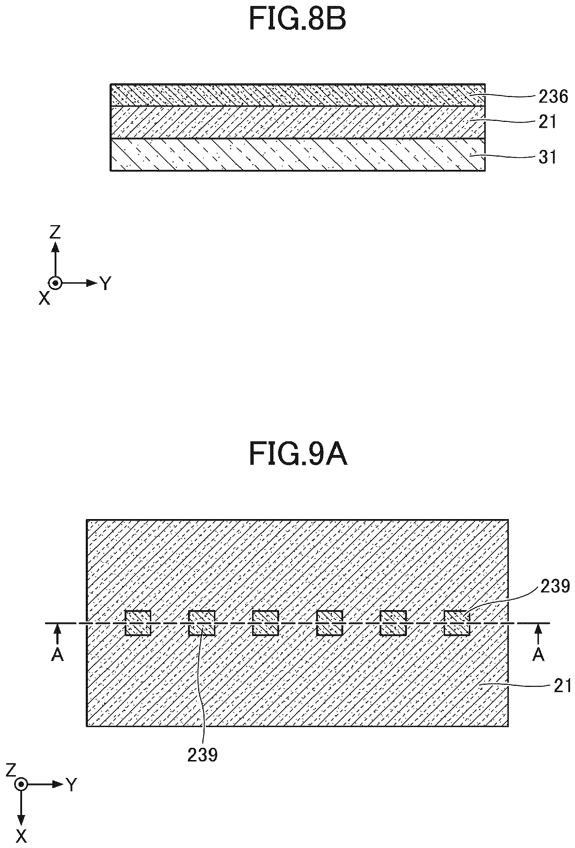

In FIG. 8A and FIG. 8B, a substrate having the first semiconductor portion 21 and the first active layer 236 provided on the first heat dissipation member 31 in this order, is manufactured. FIG. 8A is a plan view of the substrate, and FIG. 8B is a cross-sectional view of the substrate along a line A-A in FIG. 8A. As illustrated in FIG. 8A, the first active layer 236 is a ridge extending in one direction on the first semiconductor portion 21. The first active layer 236 extends along a longitudinal direction of the substrate, and two mutually opposing surfaces, that are orthogonal to the longitudinal axis of the first active layer 236, become the side surface 201 and the side surface 202 through which the light is input and output.

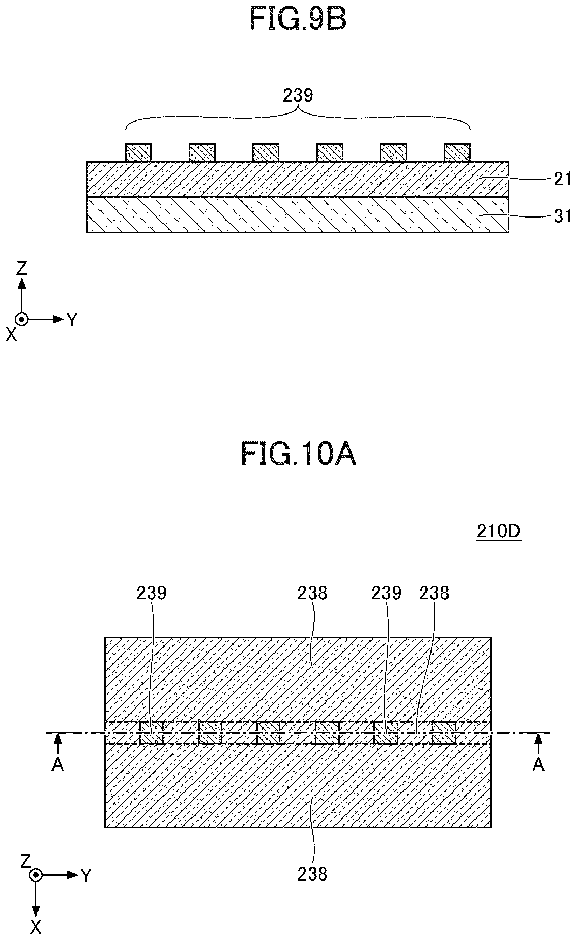

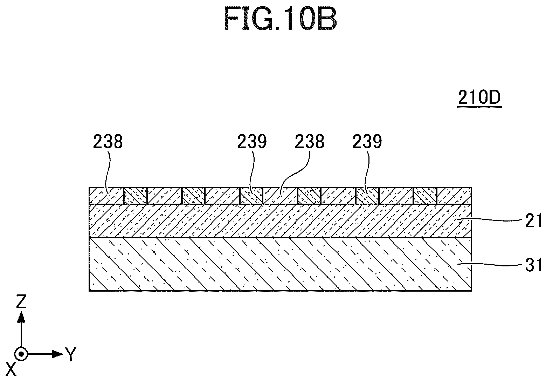

In FIG. 9A and FIG. 9B, the ridge-shaped first active layer 236 is etched to form a periodic pattern 239. The periodic pattern 239 is formed of the first active layer 236. FIG. 9A is a plan view, and FIG. 9B is a cross-sectional view along a line A-A in FIG. 9A. In FIG. 10A and FIG. 10B, a regrown layer 238 is formed, and a surface of the regrown layer 238 is planarized. FIG. 10A is a plan view, and FIG. 10B is a cross-sectional view along a line A-A in FIG. 10A. The regrown layer 238 may be made of a material identical to the material used for the first semiconductor portion 21. Thus, a first chip 210D having the periodic pattern 239 can be obtained. The surface of the regrown layer 238 provided between adjacent patterns of the periodic pattern 239 may be coplanar with the surface of other regrown layer 238 adjacent to the first active layer 236. The regrown layer 238 is adjacent to the first active layer 236 in a direction perpendicular to both the layering direction of the first active layer 236 and the direction in which the periodic pattern 239 of the first active layer 236 periodically occurs. The regrown layer 238 forms a third semiconductor portion after the first chip 210D and the second chip 220D are bonded together.

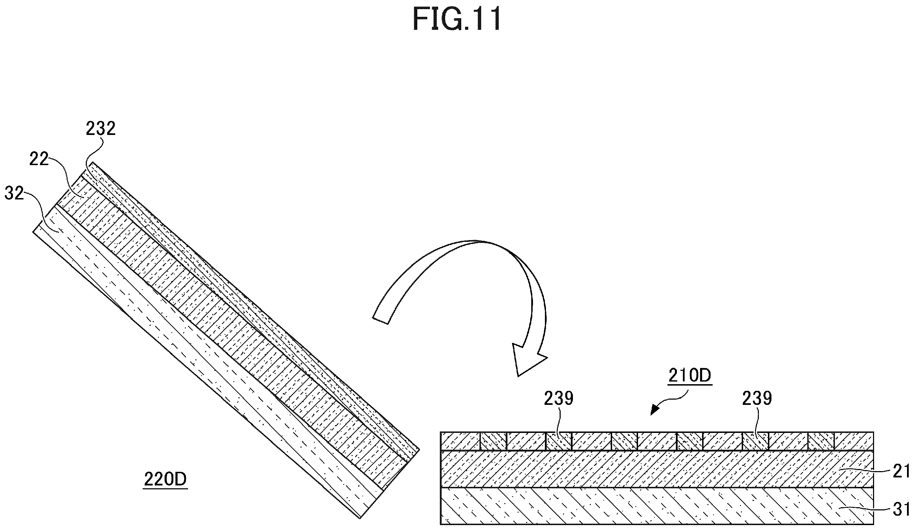

In FIG. 11, the second chip 220D is bonded to the first chip 210D. The second chip 220D includes the second semiconductor portion 22 formed on the second heat dissipation member 32, and the second active layer 232 formed on the second semiconductor portion 22. The periodic pattern 239 and the second active layer 232 are positioned to oppose each other and are aligned, before bonding the first chip 210D and the second chip 220D by the surface activated bonding, the atomic diffusion bonding, the hydroxyl bonding, or the like. The second active layer 232 may have a stripe shape, or a periodic pattern. In this state, a regrown layer is provided in a direction perpendicular to both the layering direction of the second active layer 232 and the direction in which the stripes of the stripe shape of the second active layer 232 extend or the direction in which the periodic pattern of the second active layer 232 periodically occurs. The regrown layer is adjacent to the second active layer 232. After the first chip 210D and the second chip 220D are bonded together, the regrown layer forms a third semiconductor portion.

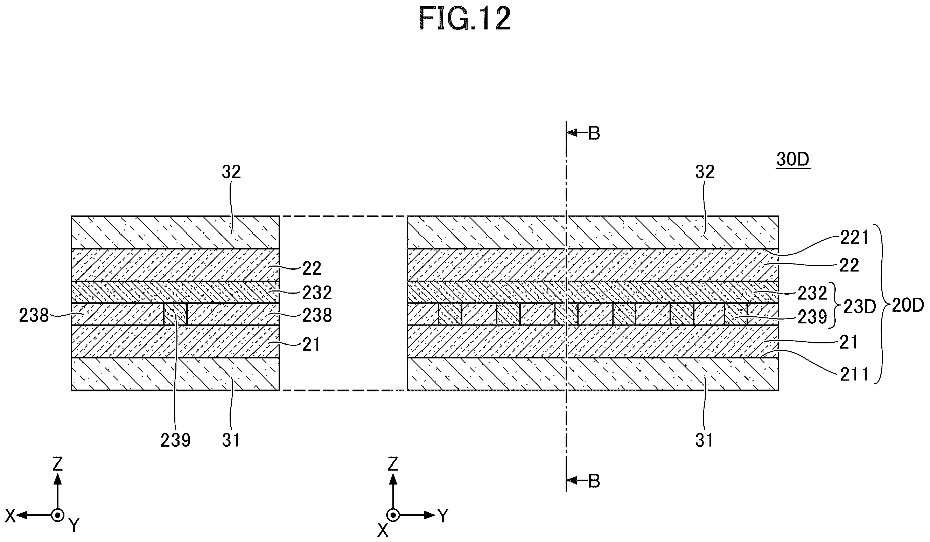

FIG. 12 is a schematic diagram of the gain chip 30D manufactured by the third manufacturing process. In FIG. 12, a cross-sectional view parallel to the XZ-plane illustrated on the left side, is a cross-sectional view along a line B-B in a cross-sectional view parallel to the YZ-plane illustrated on the right side. The gain chip 30D includes a gain medium 20D, the first heat dissipation member 31 provided on the first principal surface 211 of the gain medium 20D, and the second heat dissipation member 32 provided on the second principal surface 221 of the gain medium 20D. The gain medium 20D includes the first semiconductor portion 21, the second semiconductor portion 22, and the first active layer 236 and the second active layer 232 provided between the first semiconductor portion 21 and the second semiconductor portion 22. The first active layer 236 forms the periodic pattern 239 as described above with reference to FIG. 8A and FIG. 8B. The regrown layer (or third semiconductor portion) 238 is adjacent to the first active layer 236 (that is, the periodic pattern 239) in the direction perpendicular to both the layering direction of the first active layer 236 and the direction in which the periodic pattern 239 of the first active layer 236 periodically occurs. When the gain medium 20D is disposed inside the resonator 10, the first active layer 236 is periodically provided along the optical axis 15 of the resonator 10 in the regions parallel to the optical axis 15. Due to this configuration of the gain chip 30D, it is possible to reduce the absorption of the excitation light Lpump in the regions where the excitation is not required, and maintain a high gain.

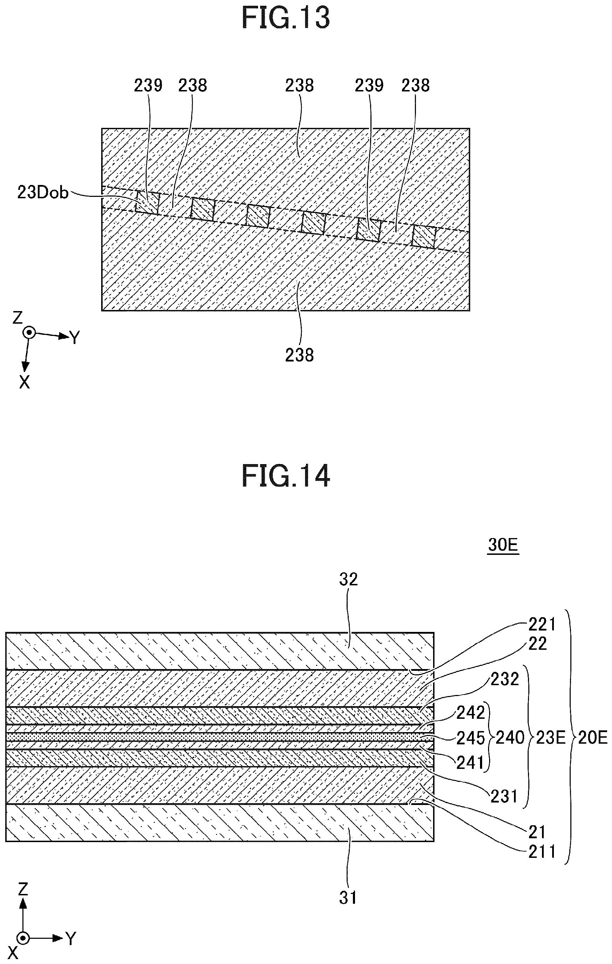

In a case where the third manufacturing process is applied to the light source device 2B in which the resonant light Lrsn is incident on the side surface 201 of the gain medium 20 at the Brewster's angle as illustrated in FIG. 3B, the first active layer 236 provided as the periodic pattern 239 in the process of FIG. 10A may be formed as an active layer 23Dob extending obliquely at the Brewster's angle with respect to a light incident surface (side surface 201) of the gain medium 20D as illustrated in FIG. 13. In this case, it is possible to efficiently perform excitation and amplification, by reducing reflection.

### <Modifications of Gain Chip>

### <First Modification>

FIG. 14 schematically illustrates a gain chip 30E, which is a first modification of the gain chip 30. The gain chip 30E includes a gain medium 20E, the first heat dissipation member 31 provided on the first principal surface 211 of the gain medium 20E, and the second heat dissipation member 32 provided on the second principal surface 221 of the gain medium 20E. In the gain medium 20E, the first semiconductor portion 21, an active layer 23E, and the second semiconductor portion 22 are arranged in this order. The active layer 23E includes a first active layer 231, a second active layer 232, and an intermediate layer 240 provided between the first active layer 231 and the second active layer 232. In the first modification, the active layer 23E may include at least the first active layer 231 and the intermediate layer 240, the first active layer 231 may be in contact with one of the first semiconductor portion 21 and the second semiconductor portion 22, and the intermediate layer 240 may be disposed between the first active layer 231 and the other of the first semiconductor portion 21 and the second semiconductor portion 22.

The intermediate layer 240 is used when bonding a first chip having the first active layer 231, and a second chip having the second active layer 232 together. The intermediate layer 240 includes a first intermediate layer 241 in contact with the first active layer 231, and a second intermediate layer 242 in contact with the second active layer 232. In addition, the intermediate layer 240 may include a bonding layer 245 provided between the first intermediate layer 241 and the second intermediate layer 242. The bonding layer 245 may be formed when the first intermediate layer 241 and the second intermediate layer 242 are directly bonded to each other. The bonding layer 245 may be omitted. In the case where the first semiconductor portion 21 and the second semiconductor portion 22 are formed of the GaN-based semiconductor material, for example, the first intermediate layer 241 and the second intermediate layer 242 may be GaN layers, and the bonding layer 245 may be an AlN layer. The first intermediate layer 241, the second intermediate layer 242, and the bonding layer 245 are thin, and a thickness of the entire intermediate layer 240 may be greater than or equal to 50 nm and less than or equal to several hundred nm, for example.

The intermediate layer 240 includes at least one of a metal, an oxide, a nitride, and a fluoride. In the case where the intermediate layer 240 is a metal, the metal may be at least one element selected from a group consisting of aluminum, gold, silver, copper, gallium, silicon, nickel, platinum, titanium, ruthenium, and tantalum, for example. In the case where the intermediate layer 240 is an oxide, the oxide may be at least one oxide selected from a group consisting of silicon oxide, aluminum oxide, gallium oxide, tantalum oxide, and hafnium oxide, for example. In the case where the intermediate layer 240 is a nitride, the nitride may be at least one nitride selected from a group consisting of gallium nitride, aluminum nitride, and silicon nitride, for example. In the case where the intermediate layer 240 is a fluoride, the fluoride may be at least one fluoride selected from a group consisting of magnesium fluoride, calcium fluoride, or the like, for example. The gain chip 30E having a high heat dissipation performance can be obtained using such materials for the intermediate layer 240. Each layer forming the intermediate layer 240 may be formed of identical materials. The first intermediate layer 241 and the second intermediate layer 242 can be formed by CVD, sputtering, vapor deposition, or the like, for example. The first intermediate layer 241 and the second intermediate layer 242 are preferably a layer having a refractive index identical to a refractive index of the first active layer 231 or the second active layer 232, or a layer having a refractive index close to a refractive index of the first semiconductor portion 21 and the second semiconductor portion 22. From this viewpoint, gallium nitride or aluminum nitride is preferably used for the first intermediate layer 241 and the second intermediate layer 242.

Each of the first intermediate layer 241 and the second intermediate layer 242 may be an amorphous layer. In this case, it is possible to reduce effects of a polarity of the active layer, and increase a bonding strength. Each of the first intermediate layer 241 and the second intermediate layer 242 may have a surface roughness (Ra) less than or equal to 5 nm, and preferably less than or equal to 1 nm, for example. By planarizing the first intermediate layer 241 and second intermediate layer 242 so as to have the surface roughness (Ra) described above, it is possible to obtain a flatness required for the direct bonding of the first intermediate layer 241 and the second intermediate layer 242 is obtained. In addition, because the intermediate layer is planarized in place of the active layer, damage to the active layer can be reduced. A thickness of each of the first intermediate layer 241 and the second intermediate layer 242 may be in a range greater than or equal to 10 nm and less than or equal to 50 nm, for example, and unlikely interferes with the amplification in the first active layer 231. In this case, the gain chip 30E having a high efficiency of amplification and a high heat dissipation performance can be obtained.

### <Second Modification>

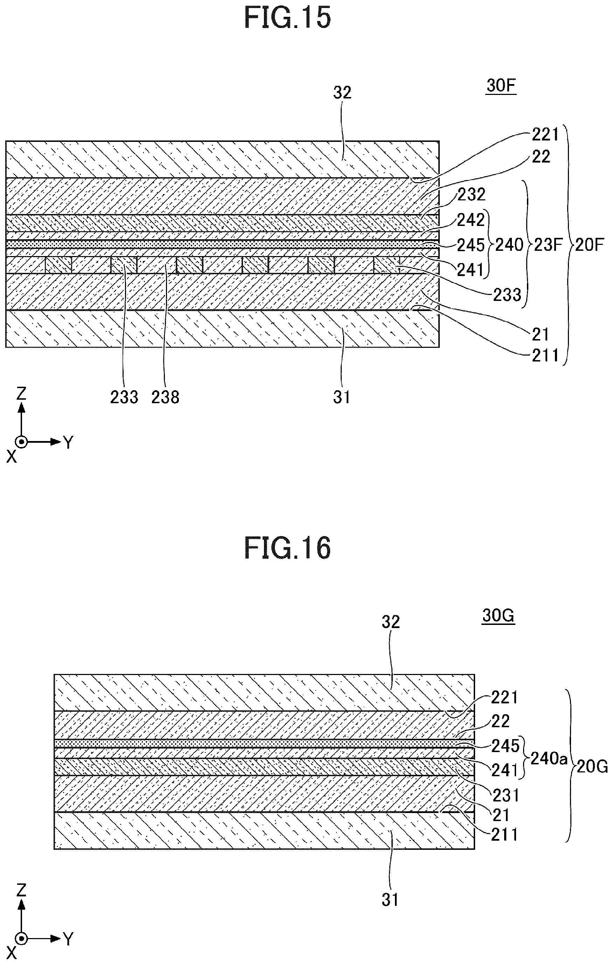

FIG. 15 schematically illustrates a gain chip 30F, which is a second modification of the gain chip 30. The second modification differs from the first modification in that the first active layer included in an active layer 23F forms the periodic pattern 233, and the regrown layer 238 is formed between adjacent patterns of the periodic pattern 233 formed by the first active layer. When the gain chip 30F is disposed inside the resonator 10, the periodic pattern 233 may have the RPG structure. In this case, the gain chip 30F having a high efficiency of amplification and a high heat dissipation performance can be obtained.

### <Third Modification>

FIG. 16 schematically illustrates a gain chip 30G, which is a third modification of the gain chip 30. The gain chip 30G includes an intermediate layer 240a provided between the first active layer 231 on the first semiconductor portion 21, and the second semiconductor portion 22. The gain chip 30G includes a gain medium 20G, the first heat dissipation member 31 provided on the first principal surface 211 of the gain medium 20G, and the second heat dissipation member 32 provided on the second principal surface 221 of the gain medium 20G. In the gain medium 20G, the first semiconductor portion 21, the first active layer 231, the intermediate layer 240a, and the second semiconductor portion 22 are arranged in this order. The intermediate layer 240a includes a first intermediate layer 241, and a bonding layer 245. The gain chip 30G of the third modification differs from the gain chip 30E of the first modification in that the second intermediate layer 242 is not provided.

A thickness of the intermediate layer 240a, including the first intermediate layer 241 and the bonding layer 245, may be in a range greater than or equal to 20 nm and less than or equal to 100 nm, for example, and unlikely interferes with the amplification in the first active layer 231. In this case, the gain chip 30G having a high efficiency of amplification and a high heat dissipation performance can be obtained.

### <Fourth Modification>

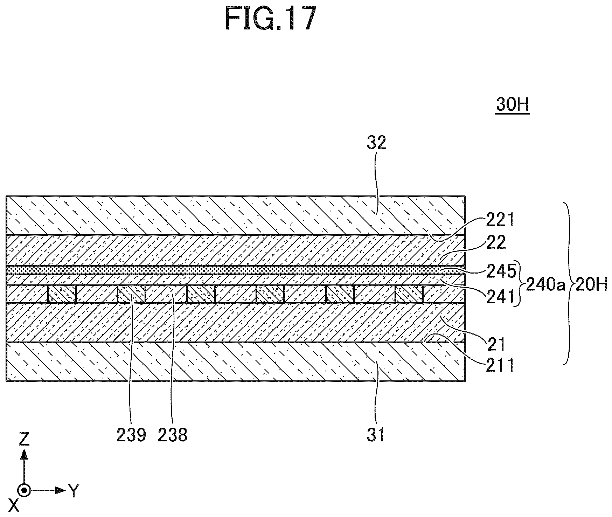

FIG. 17 schematically illustrates a gain chip 30H, which is a fourth modification of the gain chip 30. The fourth modification differs from the third modification in that the first active layer 231 (refer to FIG. 16) forms the periodic pattern 239, and the regrown layer 238 is formed between adjacent patterns of the periodic pattern 239 formed by the first active layer 231. When the gain chip 30H is disposed inside the resonator 10, the periodic pattern 239 may have the RPG structure. In this case, the gain chip 30H having a high efficiency of amplification and a high heat dissipation performance can be obtained.

### <Fifth Modification>

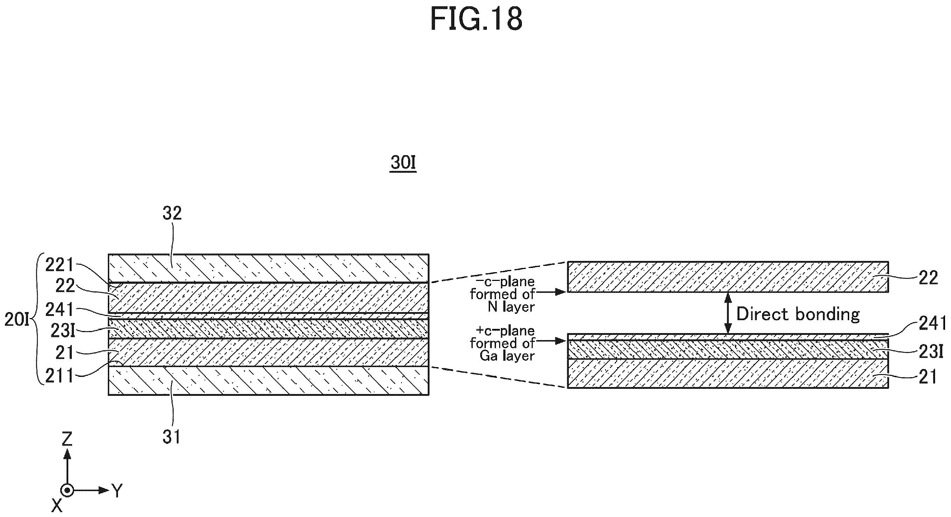

FIG. 18 schematically illustrates a gain chip 301, which is a fifth modification of the gain chip 30. In the gain chip 301, an active layer 231 on the first semiconductor portion 21, and the second semiconductor portion 22 are bonded via an amorphous first intermediate layer 241 that is provided as an intermediate layer. The gain chip 301 includes a gain medium 201, the first heat dissipation member 31 provided on the first principal surface 211 of the gain medium 201, and the second heat dissipation member 32 provided on the second principal surface 221 of the gain medium 201. In the gain medium 201, the first semiconductor portion 21, the active layer 231, the first intermediate layer 241, and the second semiconductor portion 22 are arranged in this order. The first semiconductor portion 21 and the second semiconductor portion 22 may be formed of GaN, for example.

The amorphous first intermediate layer 241 is formed on the active layer 231. In one example, a surface of the active layer 23I is a +c-plane (or +c-face) orthogonal to the crystallographic axis (c-axis), and is a Ga-face.

In one example, a bonding surface of the second semiconductor portion 22 is a -c-plane (or -c-face) orthogonal to the c-axis, and is an N-face. In this case, the second heat dissipation member 32 may be disposed on one surface of the second semiconductor portion 22, and the other surface (-c-plane) of the second semiconductor portion 22 may be used for the bonding. By bonding the active layer 23I and the second semiconductor portion 22 via the amorphous first intermediate layer 241, the bonding strength can be increased.

The amorphous first intermediate layer 241 is a thin layer provided parallel to the active layer 23I. and does not interfere with the amplification in the active layer 23I. In this case, the gain chip 30I having a high efficiency of amplification and a high heat dissipation performance can be obtained.

### <Sixth Modification>

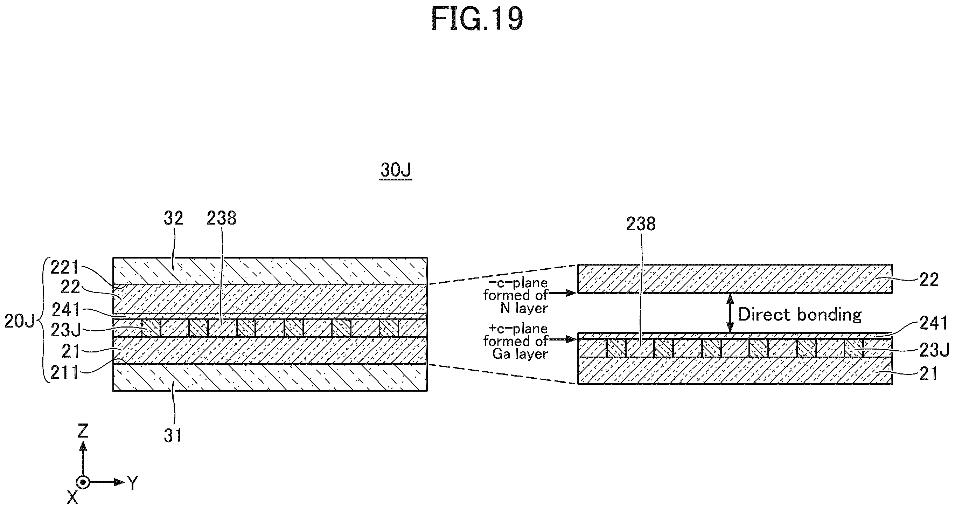

FIG. 19 schematically illustrates a gain chip 30J, which is a sixth modification of the gain chip 30. The gain chip 30J of the sixth modification differs from the gain chip 30I of the fifth modification in that the active layer 23J forms a periodic pattern, and a regrown layer 238 is formed between adjacent patterns of the periodic pattern formed by the active layer 23J. The regrown layer 238 may be made of a material identical to the material used for the first semiconductor portion 21, for example.

The first intermediate layer 241 is a thin layer provided parallel to the active layer 23J, and does not interfere with the amplification in the active layer 23J, and the periodic pattern of the active layer 23J can ensure efficient excitation and amplification. When the gain chip 30J is disposed inside the resonator 10, the periodic pattern 239 may have the RPG structure. In this case, the gain chip 30J having high efficiency of amplification and a high heat dissipation performance can be obtained.

### <Modification of Light Source Device>

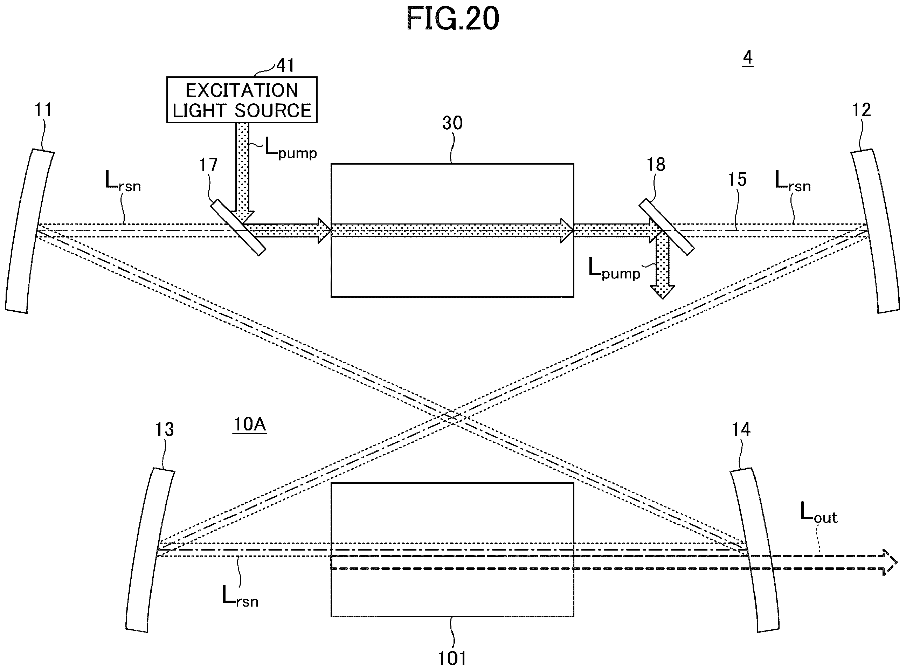

FIG. 20 illustrates a light source device 4, which is another modification of the light source device. The light source device 4 includes a bow-tie resonator 10A having four mirrors. The resonator 10A includes the first mirror 11, the second mirror 12, a third mirror 13, and a fourth mirror 14. The resonant light Lrsn is successively reflected by the second mirror 12, the third mirror 13, the fourth mirror 14, and the first mirror 11 and makes round-trips in the resonator 10A, and the resonant light Lrsn is amplified by the gain chip 30 for each round-trip.

A wavelength conversion element 101 may be disposed on the optical path inside the resonator 10A to generate a harmonic. The harmonic is extracted as output light Lout from the fourth mirror 14, for example. For example, light with a first harmonic wave (fundamental wave) having a wavelength of 460 nm is generated and amplified by the gain chip 30 formed of the GaN-based material. Ultraviolet light having a wavelength of 230 nm is generated by the wavelength conversion element 101. The wavelength conversion element 101 is a nonlinear optical crystal, for example, and light having a wavelength (or frequency) different from that of incident light is generated by incident light having a high intensity. The wavelength conversion element 101 may be a BBO (β-BaB₂O₄) crystal, an LBO (LiBa₃O₅) crystal, a CLBO (CsLiB₆O₁₀) crystal, a KDP (KH₂PO₄) crystal, a KTP (KTiOPO₄) crystal, or a LN (LiNbO₃) crystal, for example. A length of the wavelength conversion element 101 in the direction of the optical axis 15 is set so that a phase matching condition is satisfied by a light incident surface and a light emitting surface.

As an example, a curvature radius R of the third mirror 13 and the fourth mirror 14 may be in a range greater than or equal to 50 mm and less than or equal to 100 mm, and a distance between the third mirror 13 and the fourth mirror 14 may be in a range greater than or equal to 50 mm and less than or equal to 100 mm. In this case, the beam diameter of the excitation light Lrsn may be in a range greater than or equal to 20 um and less than or equal to 30 um at the input and output surfaces of the wavelength conversion element 101, and approximately 100 um at the input and output surfaces of the gain chip 30.

The excitation light Lpump emitted from the excitation light source 41 is incident on the gain chip 30 via the optical element 17, parallel to the optical axis 15 of the resonant light Lrsn. The surplus excitation light Lpump transmitted through the gain chip 30 may be emitted to the outside of the resonator 10A via the optical element 18. As illustrated in FIG. 3B, the gain chip 30 may be disposed obliquely with respect to the optical axis 15 of the resonator 10A, so that the resonant light Lrsn is incident on the gain chip 30 at the Brewster's angle. Similarly to the gain chip 30, the wavelength conversion element 101 may be disposed obliquely with respect to the optical axis 15 of the resonator 10A, so that the resonant light Lrsn is incident on the wavelength conversion element 101 at the Brewster's angle. In this case, it is possible to reduce reflection at the light incident surface and the light emitting surface of the wavelength conversion element 101. A high-output ultraviolet light source can be obtained using the light source device 4.

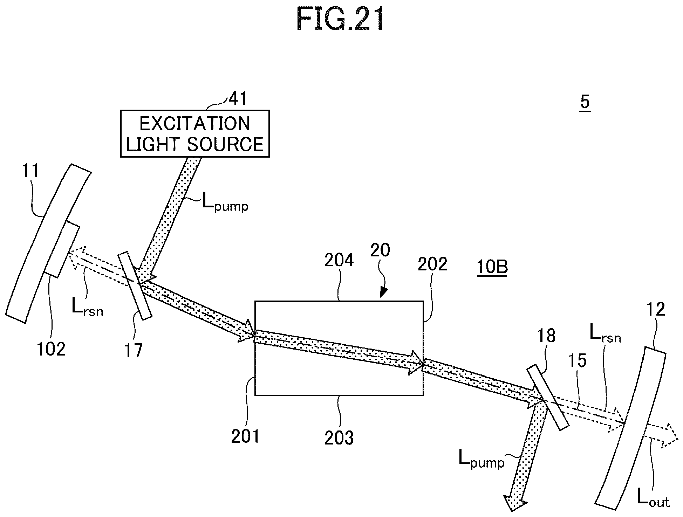

FIG. 21 illustrates a light source device 5, which is another modification of the light source device. The light source device 5 includes a resonator 10B, the gain medium 20 inside the resonator 10B, and a saturable absorber 102. The gain medium 20 is disposed obliquely with respect to the optical axis 15 of the resonator 10B, so that the resonant light Lrsn is incident on the incident surface (side surface 201) of the gain medium 20 at the Brewster's angle, but the arrangement of the gain medium 20 is not limited to this example.

The saturable absorber 102 has a recovery time shorter than a round-trip time of the resonant light Lrsn, and is approximately transparent with respect to a center portion (that is, a center region with a high intensity) of a pulse of the incident excitation light Lrsn, but absorbs light at a foot portion of the pulse where the intensity decreases. As a result, the resonant light Lrsn is pulsed (or mode-locked), and the pulsed light is output from the second mirror 12. The light source device 5 can be used as a high-power single-mode pulsed light source.

### <Modification of Gain Chip>

The gain chip, which is an example of a semiconductor device, may have the following configuration, for example. The semiconductor device may include a gain medium having a first semiconductor portion, an active layer, and a second semiconductor portion that are arranged in this order, where the gain medium includes a first principal surface located on a side of the first semiconductor portion opposite to a side of the first semiconductor portion on which the active layer is provided, and a second principal surface located on a side of the second semiconductor portion opposite to a side of the second semiconductor portion on which the active layer is provided. The semiconductor device may include a first heat dissipation member provided on a first principal surface side of the gain medium , and a second heat dissipation member provided on a second principal surface side of the gain medium. One or both of the first semiconductor portion and the second semiconductor portion may include a portion including an impurity with a concentration less than or equal to 1 × 10¹⁷ cm⁻³. The active layer may include at least a first active layer and an intermediate layer. The first active layer may be in contact with one of the first semiconductor portion and the second semiconductor portion. The intermediate layer may be disposed between the first active layer and the other of the first semiconductor portion and the second semiconductor portion. The intermediate layer may include at least one of an oxide, a nitride, a fluoride, and a metal. Thus, a semiconductor device having a high heat dissipation performance can be obtained.

The present invention is not limited to the configuration examples described above. A saturable absorber may be used in the bow-tie resonator 10A of FIG. 20. The layer structure of the gain medium 20 may adopt any of the configurations of the embodiments and the modifications described above. In any case, the resonant light Lrsn passes through the gain medium 20 along the optical axis of the resonator, and the interaction length of the resonant light and the active layer can be made long, thereby enabling efficient amplification. Because the first heat dissipation member 31 and the second heat dissipation member 32 are provided on the two surfaces (the first principal surface 211 and the second principal surface 221) parallel to the active layer of the gain medium 20, the heat dissipation performance can be improved.

Accordingly to each of the embodiments described above, it is possible to provide a light source device having high heat dissipation.

Although the modifications are numbered with, for example, "first," "second," "third," ..., the ordinal numbers do not imply priorities of the modifications. Many other variations and modifications will be apparent to those skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions. The organization of such examples in the specification does not relate to a showing of the superiority and inferiority of certain embodiments. Although the embodiments of the present invention have been described in detail, it should be understood that the various changes, substitutions, and alterations could be made hereto without departing from the spirit and scope of the invention.

## Claims

1. A light source device comprising:
a resonator comprising a first mirror and a second mirror;
a gain medium disposed between the first mirror and the second mirror, wherein:
the gain medium comprises a first semiconductor portion, an active layer, and a second semiconductor portion that are arranged in this order in a direction perpendicular to an optical axis of the resonator,
a first principal surface of the gain medium is located on a side of the first semiconductor portion opposite to a side of the first semiconductor portion on which the active layer is provided, and
a second principal surface of the gain medium is located on a side of the second semiconductor portion opposite to a side of the second semiconductor portion on which the active layer is provided;
a first heat dissipation member located on a first principal surface side of the gain medium; and
a second heat dissipation member located on second principal surface side of the gain medium; wherein:
the resonator and the gain medium are arranged such that the optical axis of the resonator passes through the gain medium.

2. The light source device as claimed in claim 1, further comprising:
an excitation light source disposed outside the resonator; wherein:
excitation light emitted from the excitation light source is incident on the active layer of the gain medium along the optical axis of the resonator.

3. The light source device as claimed in claim 1, further comprising:
an excitation light source disposed outside the resonator;
wherein excitation light emitted from the excitation light source is incident on the active layer of the gain medium in a direction intersecting the optical axis of the resonator.

4. The light source device as claimed in any one of claims 1 to 3, wherein:
the gain medium has a side surface connecting the first principal surface and the second principal surface; and
resonant light is incident on the side surface of the gain medium at a Brewster's angle.

5. The light source device as claimed in any one of claims 1 to 5, wherein:
the active layer comprises a first active layer, and an intermediate layer;
the first active layer is in contact with one of the first semiconductor portion and the second semiconductor portion; and
the intermediate layer is disposed between the first active layer and the other of the first semiconductor portion and the second semiconductor portion.

6. The light source device as claimed in claim 5, wherein:
the intermediate layer comprises at least one of a metal, an oxide, a nitride, and a fluoride.

7. The light source device as claimed in any one of claims 1 to 6, wherein:
the gain medium is formed of a nitride semiconductor, and the first heat dissipation member and the second heat dissipation member are formed of a metal nitride.

8. The light source device as claimed in any one of claims 1 to 7, wherein:
the active layer has a thickness greater than or equal to 50 nm and less than or equal to 2000 nm.

9. The light source device as claimed in any one of claims 1 to 8, wherein:
the active layer has a periodic pattern; and
a direction in which the periodic pattern periodically occurs is parallel to a direction in which the optical axis of the resonator extends.

10. The light source device as claimed in claim 9, wherein:
the gain medium further comprises a third semiconductor portion; and
the third semiconductor portion is adjacent to the active layer in a direction perpendicular to both a layering direction of the active layer and the direction in which the periodic pattern periodically occurs.

11. The light source device as claimed in any one of claims 1 to 10, wherein:
at least one of the first semiconductor portion and the second semiconductor portion comprises a portion including an impurity with a concentration less than or equal to 1 × 10¹⁷ cm⁻³.

12. A semiconductor device comprising:
a gain medium comprising a first semiconductor portion, an active layer, and a second semiconductor portion that are arranged in this order, wherein:
a first principal surface of the gain medium is located on a side of the first semiconductor portion opposite to a side of the first semiconductor portion on which the active layer is provided, and
a second principal surface of the gain medium is located on a side of the second semiconductor portion opposite to a side of the second semiconductor portion on which the active layer is provided;
a first heat dissipation member located on a first principal surface side of the gain medium; and
a second heat dissipation member located on a second principal surface side of the gain medium; wherein:
one or both of the first semiconductor portion and the second semiconductor portion comprise a portion including an impurity with a concentration less than or equal to 1 × 10¹⁷ cm-³;
the active layer comprises a first active layer and an intermediate layer;
the first active layer is in contact with one of the first semiconductor portion and the second semiconductor portion;
the intermediate layer is disposed between the first active layer and the other of the first semiconductor portion and the second semiconductor portion; and
the intermediate layer comprises at least one of an oxide, a nitride, a fluoride, and a metal.
